(19) Europäisches Patentamt
European Patent Office
Office européen des brevets

(11) **EP 3 236 492 A1**

(12) **EUROPÄISCHE PATENTANMELDUNG**

(43) Veröffentlichungstag:
**25.10.2017  Patentblatt 2017/43**

(51) Int Cl.:
**H01L 21/68** (2006.01)    **H01L 21/67** (2006.01)

(21) Anmeldenummer: **16165811.7**

(22) Anmeldetag: **18.04.2016**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Meyer Burger (Germany) AG
09337 Hohenstein-Ernstthal (DE)**

(72) Erfinder:
• **Ansorge, Erik
  09127 Chemnitz (DE)**
• **Böhm, Christian
  09337 Hohenstein-Ernstthal (DE)**
• **Raschke, Sebastian
  09380 Thalheim (DE)**

(74) Vertreter: **Kailuweit & Uhlemann Patentanwälte
Partnerschaft mbB
Bamberger Straße 49
01187 Dresden (DE)**

(54) **VERFAHREN UND SYSTEM ZUR STEUERUNG EINER VORRICHTUNG ZUM GREIFEN ODER POSITIONIEREN VON AUF EINEM SUBSTRATTRÄGER ANGEORDNETEN SUBSTRATEN**

(57)    Die Erfindung betrifft ein Verfahren zur Steuerung einer Vorrichtung zum Greifen oder Positionieren von mindestens einem Substrat auf einem Substratträger. Der Substratträger besteht aus einem Material mit mindestens einem bekannten Ausdehnungskoeffizienten. Bei dem Verfahren wird zunächst bei einer bekannten ersten Temperatur des Substratträgers ein erstes Parameterset des Substratträgers bestehend Länge, Breite und/oder Höhe des Substratträgers sowie die relative Position eines Substratbezugspunktes auf dem Substratträger bezüglich eines Bezugspunktes des Substratträgers ermittelt. Nachfolgend wird ein zweites Parameterset aus Länge, Breite und/oder Höhe des Substratträgers bei einer unbekannten zweiten Temperatur des Substratträgers mit Hilfe von mindestens zwei Lasersensoren ermittelt, wobei zwei der Lasersensoren auf gegenüberliegenden Seiten des Substratträgers und auf einer Laserlinie angeordnet sind. Mit Hilfe des ermittelten zweiten Parametersets und des mindestens einen Ausdehnungskoeffizienten kann die genaue Position des Substratbezugspunktes auf dem an einer ersten Position positionierten Substratträger bei der unbekannten zweiten Temperatur ermittelt und die Vorrichtung zum Greifen oder Positionieren entsprechend gesteuert werden. Das erfindungsgemäße System zur Steuerung einer Vorrichtung zum Greifen oder Positionieren weist den Verfahrensschritten entsprechende Mittel auf.

| | |
|---|---|
| Bereitstellen des Substratträgers 100 | S10 |
| Ermitteln des ersten Parametersets bei $T_0$ | S20 |
| Ermitteln der Positionen des Bezugspunktes 120 und des Substratbezugspunktes 130 bei $T_0$ sowie der Vorrichtung 200 | S30 |
| Positionieren des Substratträgers 100 bei $T_i$ an erster Position | S40 |
| Ermitteln des zweiten Parametersets bei $T_i$ an erster Position | S50 |
| Ermitteln der Position des Substratbezugspunktes 130 bei $T_i$ an erster Position | S60 |
| Steuerung der Vorrichtung 200 in Abhängigkeit von der ermittelten Position des Substratbezugspunktes 130 bei $T_i$ an erster Position | S70 |

Fig. 6

EP 3 236 492 A1

**Beschreibung**

Die Erfindung betrifft ein Verfahren und ein System zur Steuerung einer Vorrichtung zum Greifen oder Positionieren von mindestens einem Substrat auf einem Substratträger. Insbesondere dient die Vorrichtung zum Greifen oder Positionieren dem Entfernen oder Ablegen einer Mehrzahl von Substraten von bzw. auf einem Substratträger, wie dies bspw. in der Solarzellenherstellung Anwendung findet. Insbesondere können auch lichtundurchlässige Substrate gegriffen oder positioniert werden.

In vielen Bearbeitungsanlagen von Substraten in der Solarzellenherstellung, aber auch in der Displaybeschichtung, der Halbleitertechnik oder anderen Bereichen zum Beschichten von Substraten, werden Substrate für die Bearbeitung in einer Bearbeitungskammer sowie den Transport von einer Bearbeitungskammer in eine andere Bearbeitungskammer auf einem Substratträger angeordnet und letztlich dieser Substratträger dann in einer Kammer positioniert oder durch eine Kammer oder eine Schleuse oder auf einem Transportmittel bewegt. Damit müssen zu einem ersten Zeitpunkt das oder die Substrate auf dem Substratträger an vorgegebenen Positionen positioniert und zu einem späteren Zeitpunkt, z.B. nach der Bearbeitung, von Substratträger wieder definiert entfernt werden, wobei im Allgemeinen automatische Vorrichtungen zum Einsatz kommen. Der Prozess des Entfernens soll im Folgenden als Greifen bezeichnet werden, wobei Greifwerkzeuge in Form von Greiffingern oder Greifzangen, Bernoulli-Greifer, Saugnäpfe, Vakuumsauger, elektrostatische Greifer, andere auf elektromagnetischen Effekten oder auf Adhäsion beruhende Greif- und Haltemittel, Stempel oder andere geeignete Mittel zum Entfernen eingesetzt werden. Diese Einrichtungen oder Werkzeuge zum Greifen oder Positionieren greifen ein spezifisches Substrat an einem oder mehreren vorgegebenen Punkten des Substrates oder auch flächig in einem oder mehreren vorgegebenen Bereichen an, wobei die Punkte bzw. die Bereiche mit Bezug auf den Substratträger eine definierte Lage aufweisen. Sollen beispielsweise ein großes Substrat oder eine Mehrzahl kleiner Substrate von einem Substratträger entfernt werden, so wird ein Greifwerkzeug oder mehrere Greifwerkzeuge in einem räumlichen Koordinatensystem so gesteuert, dass sie in Bezug auf einen oder mehrere ermittelte Punkte innerhalb der Umfangsfläche des Substratträgers, nachfolgend Substratbezugspunkte genannt, positioniert werden und an diesen auf das oder die Substrate zugreifen. Andererseits können das oder die Substrate auch an einer Position, die durch einen oder mehrere Substratbezugspunkte vorgegeben sind, auf dem Substratträger abgelegt, d.h. positioniert, werden. Diese Substratbezugspunkte sind jeweils durch ihre Entfernungen von einem Bezugspunkt des Substratträgers in allen Richtungen eines räumlichen Koordinatensystems definiert wobei die Vorrichtung zum Greifen oder Positionieren als Ganzes bezüglich des Substratträgers in demselben Koordinatensystem mit Hilfe des Bezugspunktes des Substratträgers positioniert wird. Mit anderen Worten: Der Substratträger und die Vorrichtung zum Greifen oder Positionieren werden zueinander mit Hilfe des Bezugspunktes des Substratträgers an einer bestimmten Position im Koordinatensystem ausgerichtet und das oder die Werkzeuge zum Greifen oder Positionieren werden bezüglich der Substratbezugspunkte, die eine definierte Position in Relation zu dem Bezugspunkt des Substratträgers haben, ausgerichtet.

Diese Relation des oder der Substratbezugspunkte zum Bezugspunkt des Substratträgers wird üblicherweise für die Substratträger bei einer ersten Temperatur, z.B. im Bereich der Raumtemperatur oder einer mittleren Bearbeitungstemperatur, ermittelt. Jedoch kann die tatsächlich in dem Bereich, in dem das oder die Substrate positioniert oder gegriffen werden, vorliegende zweite Temperatur des Substratträgers von dieser ersten Temperatur abweichen. Je nach verwendetem Material des Substratträgers und der vorliegenden Differenz zwischen der ersten und der zweiten Temperatur kann die Position des oder der Substratbezugspunkte auf dem Substratträger im Bereich der Vorrichtung zum Greifen und Positionieren stark von einer Position, die auf der Grundlage der bei der ersten Temperatur ermittelten Relation des oder der Substratbezugspunkte zum Bezugspunkt des Substratträgers ermittelt wird, abweichen. Dadurch kann es zu Problemen bei der korrekten Positionierung oder Entfernung der Substrate auf bzw. von dem Substratträger kommen. Insbesondere bei sehr kleinen Substratoberflächen (im Verhältnis zur Oberfläche eines Greifwerkzeugs) oder bei Substratbezugspunkten, die sehr nah an einer Kante einer Substratoberfläche angeordnet sind, können die Substrate beim Entfernen bspw. nicht richtig gegriffen werden, so dass ein Entfernen unmöglich ist. Beim Positionieren kann hingegen bereits eine geringe Abweichung der lateralen Positionierung des Substrates bezüglich des Substratträgers zu Schädigungen des Substrates beim Auflegen auf den Substratträger oder zu Bearbeitungsfehlern bei einer Bearbeitung des Substrates führen. Weiterhin können das oder die Substrate bei der Verwendung von Greifwerkzeugen, deren Höhenzustellung nicht durch die Erkennung einer tatsächlich vorliegenden Höhe der Substratoberfläche gesteuert wird, durch eine zu starke Druckbelastung beim Greifen oder Positionieren oder durch ein Lösen der Greifwerkzeuge auf einer Höhe, die nicht der Ablagehöhe des Substrates auf dem Substratträger entspricht, geschädigt oder das oder die Substrate auch gar nicht entfernt werden.

Es ist daher Aufgabe der Erfindung, ein Verfahren zur Steuerung einer Vorrichtung zum Greifen oder Positionieren von mindestens einem Substrat auf einem Substratträger sowie ein dafür geeignetes System zur Verfügung zu stellen, mit denen ein korrektes Entfernen des mindestens einen Substrates von dem Substratträger oder eine korrekte Positionierung des mindestens einen Substrates auf dem Substratträger auch bei einer unbekannten Temperatur des Substratträgers möglich ist.

Diese Aufgabe wird gelöst durch ein Verfahren gemäß Anspruch 1 und durch ein System gemäß Anspruch 6. Vorzugsweise Ausgestaltungen des Verfahrens und des Systems sind Gegenstände der jeweiligen rückbezogenen Unteransprüche.

Das erfindungsgemäße Verfahren zur Steuerung einer Vorrichtung zum Greifen oder Positionieren von mindestens einem Substrat auf einem Substratträger umfasst das Bereitstellen eines Substratträgers, der geeignet ist, mindestens ein Substrat zu tragen, und der aus einem Material mit mindestens einem bekannten Ausdehnungskoeffizienten besteht. Das Material des Substratträgers kann auch unterschiedliche bekannte Ausdehnungskoeffizienten in verschiedene Richtungen des Materials aufweisen. Die Position des mindestens einen Substrates auf dem Substratträger wird mittels mindestens eines Substratbezugspunktes definiert. Zunächst wird ein erstes Parameterset des Substratträgers bei einer bekannten ersten Temperatur des Substratträgers ermittelt. Das erste Parameterset besteht aus je einem Wert von mindestens einem Parameter, der aus der Länge, Breite und Höhe des Substratträgers ausgewählt ist. Darüber hinaus werden bei der ersten Temperatur des Substratträgers die Positionen eines Bezugspunktes des Substratträgers und des mindestens einen Substratbezugspunktes auf dem Substratträger in einem gemeinsamen räumlichen Koordinatensystem ermittelt. Damit wird eine räumliche Relation des mindestens einen Substratbezugspunktes zum Bezugspunkt des Substratträgers bei der ersten Temperatur erfasst. Des Weiteren wird auch die Position der Vorrichtung zum Greifen oder Positionieren in dem gemeinsamen Koordinatensystem ermittelt. Unter der Ermittlung der Position der Vorrichtung zum Greifen oder Positionieren wird insbesondere die Ermittlung der Position von mindestens einer Einrichtung zum Greifen, die in der Vorrichtung zum Greifen oder Positionieren enthalten ist, innerhalb der Vorrichtung zum Greifen oder Positionieren verstanden. Die Vorrichtung zum Greifen oder Positionieren kann auch mehrere Einrichtungen zum Greifen sowie weitere Elemente, wie Steuereinrichtungen, Motoren etc. enthalten. Die Ermittlung der Positionen kann bspw. mittels mechanischer, optischer, elektrischer oder magnetischer Sensoren unter für diese Ermittlung optimalen Umgebungs- und Randbedingungen erfolgen, bspw. bei Raumtemperatur, Normalluft, ausreichend Platz zur Anordnung der Sensoren, ausreichend Zeit zur Ermittlung auch einer Vielzahl von Positionen etc., erfolgen.

Diese vorbereitenden Schritte dienen der Kalibrierung und können nur einmalig zu Beghn des Verfahrens ausgeführt werden. Jedoch ist es auch möglich, das erste Parameterset und/oder die Positionen des Bezugspunktes des Substratträgers und des mindestens einen Substratbezugspunktes mehrmals zu ermitteln. Beispielsweise können sich durch die Bearbeitung des mindestens einen Substrates die Parameter des Substratträgers bei der ersten Temperatur über die Zeit ändern, so dass eine erneute Kalibrierung vorteilhaft ist. Es ist darüber hinaus ebenfalls vorteilhaft, weitere Parametersets bei weiteren bekannten Temperaturen und/oder die Positionen des Bezugspunktes des Substratträgers und des mindestens einen Substratbezugspunktes bei diesen weiteren bekannten Temperaturen zu ermitteln, was zu einer Erhöhung der Genauigkeit des Verfahrens beitragen kann.

Um das Greifen oder Positionieren des mindestens einen Substrates von bzw. auf dem Substratträger bei einer unbekannten zweiten Temperatur korrekt auszuführen, wird weiterhin der Substratträger an einer ersten Position im Koordinatensystem bei der unbekannten zweiten Temperatur derart positioniert, dass der Bezugspunkt des Substratträgers an einer vorgegebenen Position in Bezug auf mindestens eine erste Richtung des Koordinatensystems angeordnet ist. Nachfolgend wird an dieser ersten Position ein zweites Parameterset des Substratträgers aus gleichartigen Parametern wie das erste Parameterset bei der zweiten Temperatur des Substratträgers ermittelt. Damit besteht das zweite Parameterset aus je einem Wert von demselben mindestens einen Parameter, für den bereits das erste Parameterset einen Wert enthält. Das heißt, der oder die Parameter des zweiten Parametersets sind gleich dem oder den Parametern des ersten Parametersets. Der Wert von mindestens einem Parameter des zweiten Parametersets wird mit Hilfe von mindestens zwei Lasersensoren ermittelt, wobei zwei der Lasersensoren auf gegenüberliegenden Seiten des Substratträgers und auf einer Laserlinie angeordnet sind. Auf einer Laserlinie bedeutet, dass die Strahlengänge der zwei Lasersensoren auf einer gemeinsamen geraden Linie verlaufen.

Mit Hilfe des ersten Parametersets und des zweiten Parametersets sowie der bei der ersten Temperatur des Substratträgers ermittelten Positionen des mindestens einen Substratbezugspunktes und des Bezugspunktes des Substratträgers wird anschließend unter Einbeziehung des mindestens einen Ausdehnungskoeffizienten des Materials des Substratträgers die Position des mindestens einen Substratbezugspunktes des an der ersten Position positionierten Substratträgers im Koordinatensystem mindestens bezüglich der ersten Richtung ermittelt. Dies kann bspw. mit Hilfe einer vorher, unter für die Ermittlung der Werte optimalen Messbedingungen ermittelten Wertetabelle oder Kennlinie geschehen, in der der Wert des mindestens einen Parameters des zweiten Parametersets in Bezug zu dem Wert des gleichartigen Parameters des ersten Parametersets, zu den bei der ersten Temperatur ermittelten Positionen des Bezugspunktes des Substratträgers und des mindestens einen Substratbezugspunktes sowie zu der an der ersten Position des Substratträgers eingestellten Position des Bezugspunktes des Substratträgers und zu der Position des mindestens einen Substratbezugspunktes auf dem an der ersten Position positionierten Substratträger gesetzt ist. Die Nutzung einer Wertetabelle oder Kennlinie ist insbesondere für Substratträger aus einem Material, das mindestens einen über die Temperatur nichtlinearen Ausdehnungskoeffizienten aufweist, geeignet. Die Position des mindestens einen Substratbezugspunktes kann jedoch auch mit Hilfe einer Berechnungsvorschrift ermittelt werden, insbesondere wenn der mindestens eine Ausdehnungskoeffizient des Substratträgermaterials sich linear und nur in geringem Maße mit der Temperatur ändert.

In Abhängigkeit von der derart ermittelten Position des mindestens einen Substratbezugspunktes im Koordinatensystem bei der unbekannten zweiten Temperatur wird nunmehr die Vorrichtung zum Greifen oder Positionieren von mindestens einem Substrat gesteuert. Damit kann die mindestens eine Einrichtung zum Greifen sehr genau entsprechend der realen Position des mindestens einen Substratbezugspunktes positioniert und damit das mindestens eine Substrat auch bei einer unbekannten Temperatur des Substratträgers korrekt gegriffen oder abgelegt werden.

Mit dem erfindungsgemäßen Verfahren kann die Vorrichtung zum Greifen oder Positionieren exakt an die an der ersten Position des Substratträgers vorliegende Position des mindestens einen Substratbezugspunktes zumindest bezüglich der ersten Richtung des Koordinatensystems angepasst werden, ohne direkt bzw. unmittelbar die Position des mindestens einen Substratbezugspunktes auf dem an der ersten Position positionierten Substratträgers ermitteln zu müssen. Eine direkte Positionsermittlung kann bei den an der ersten Position des Substratträgers vorliegenden Umgebungs- und Randbedingungen unmöglich oder unvorteilhaft sein, da bspw. die vorliegende zweite Temperatur und hochreaktive Prozessgase in der Umgebungsatmosphäre sowie ein mangelndes Platzangebot und eine für die Ermittlung begrenzte Zeit dies nicht mit der notwendigen Genauigkeit erlauben. Insbesondere können ein oder mehrere Substrate auf einem Substratträger abgelegt oder von diesem entfernt werden, ohne eine vorgegebene Temperatur des Substratträgers einstelen zu müssen. Damit entfallen Wartezeiten zum Aufheizen oder Abkühlen des Substratträgers von einer Temperatur, die nicht der vorgegebenen Temperatur entspricht, auf die vorgegebene Temperatur. Darüber hinaus werden Schäden an dem mindestens einen Substrat beim Ablegen auf oder Entfernen von dem Substratträger und fehlerhafte Bearbeitungen des mindestens einen Substrates infolge einer ungenauen Auflage des mindestens einen Substrates auf dem Substratträger vermieden.

Vorteilhafterweise wird der Substratträger derart an der ersten Position positioniert, dass der Bezugspunkt des Substratträgers an einer vorgegebenen Position in Bezug auf alle Richtungen des Koordinatensystems angeordnet ist. Damit kann die Position des mindestens einen Substratbezugspunktes auf dem Substratträger an dieser ersten Position bei der zweiten Temperatur bezüglich aller Richtungen des Koordinatensystems ermittelt werden. Im Ergebnis ist eine noch genauere Positionierung der Vorrichtung zum Greifen oder Positionieren an die an der ersten Position des Substratträgers vorliegende Position des mindestens einen Substratbezugspunktes realisierbar, da nunmehr die Position des mindestens einen Substratbezugspunktes bezüglich aller Richtungen des Koordinatensystems ermittelt wurde.

In einer bevorzugten Ausführungsform werden zum Ermitteln des Wertes eines Parameters mindestens drei Lasersensoren genutzt. Damit kann eine Verdrehung des Substratträgers gegenüber einer Ausgangsposition, bei der die Positionen des Bezugspunktes des Substratträgers und des mindestens einen Substratbezugspunktes bei der ersten Temperatur ermittelt wurden, erkannt und ihre Größe ermittelt werden. Diese Verdrehung wird dann bei der Ermittlung der Position des mindestens einen Substratbezugspunktes des an der ersten Position positionierten Substratträgers mit der zweiten Temperatur einbezogen, so dass die Steuerung der Vorrichtung zum Greifen oder Positionieren auch eine solche Verdrehung des Substratträgers beachten und ausgleichen kann. In besonders bevorzugter Weise ist einer der mindestens drei Lasersensoren nicht auf einer Laserlinie mit zwei anderen dieser Lasersensoren, jedoch auf derselben Seite des Substratträgers wie einer dieser zwei anderen Lasersensoren angeordnet.

Die Verwendung von Lasersensoren zum Ermitteln mindestens des zweiten Parametersets hat viele Vorteile. Zum Einen ist damit ein berührungsloses Ermitteln des Parametersets bei beliebigen Temperaturen möglich. Auch Substratträger mit einer stark reflektierenden Oberfläche, wie sie bspw. bei einem Substratträger aus Aluminium vorliegen, können mit den Lasersensoren sehr genau und reproduzierbar vermessen werden. Auch Beschichtungen erschweren den Messvorgang nicht. Des Weiteren ist die Verwendung von Lasersensoren vakuumkompatibel und führt zu keiner Verunreinigung des Prozessraums oder einer lokalen Rückwirkung auf die Messgröße. Darüber hinaus sind Messungen auch bei Vorliegen eines Plasmas möglich, wobei weder das Plasma die Messung, noch die Messung das Plasma beeinflusst. Auch hochreaktive Prozessgase oder elektromagnetische Felder haben keinen Einfluss auf das Messergebnis. Da die Lasersensoren außerhalb einer Bearbeitungs- oder sonstigen Kammer, in der sich der Substratträger an der ersten Position befindet, angeordnet werden kann, unterliegen die Sensoren auch kaum einem Verschleiß.

Vorteilhafterweise wird das erste Parameterset mittels Lasersensoren, die gleichartig zu den Lasersensoren, mit denen das zweite Parameterset ermittelt wird, ermittelt. Dies erhöht die Genauigkeit der Positionsermittlung des mindestens einen Substratbezugspunktes bei der zweiten Temperatur noch weiter.

Vorzugsweise wird der Substratträger an der ersten Position mit Hilfe eines mechanischen Anschlages oder eines elektrischen, magnetischen oder optischen Sensors positioniert. Dies ermöglicht die genaue Positionierung des Bezugspunktes des Substratträgers an einer vorgegebenen Position zumindest in Bezug auf eine erste Richtung des Koordinatensystems, indem der Substratträger selbst oder ein Bewegungssystem zum Bewegen des Substratträgers bei Erreichen des mechanischen Anschlags oder bei Ansprechen des elektrischen, magnetischen oder optischen Sensors angehalten wird.

Zusätzlich zur genauen Ermittlung der Position des mindestens einen Substratbezugspunktes wird vorzugsweise mit Hilfe des ersten Parametersets und des zweiten Parametersets des Substratträgers unter Einbeziehung des mindestens einen Ausdehnungskoeffizienten des Materials des Substratträgers die zweite Temperatur des Substratträgers ermittelt. Damit ist eine genaue Kontrolle des Temperaturverlaufes bspw. eines Prozesses in einer Behandlungskammer, in der die erste Position des Substratträgers angeordnet ist, oder in einer unmittelbar vor oder nach dieser ersten Position entlang einer Prozesslinie des mindestens einen Substrates angeordneten Behandlungskammer möglich, wodurch letztlich auch eine Steuerung der Prozessparameter dieses Prozesses besser realisiert werden kann.

Unter einer Prozesslinie wird die Abfolge von zeitlich aufeinanderfolgenden Schritten zur Prozessierung, d.h. Bearbeitung in Form von Erzeugen oder Entfernen von Schichten auf bzw. von dem mindestens einen Substrat, Inspektion, Transport, Positionieren, Aufheizen bzw. Kühlen oder Schleusen, eines Substrates verstanden.

Das erfindungsgemäße System zur Steuerung einer Vorrichtung zum Greifen oder Positionieren von mindestens einem Substrat auf einem Substratträger enthält mindestens sechs Vorrichtungen. Dabei dient eine erste Vorrichtung zum Ermitteln eines ersten Parametersets des Substratträgers bestehend aus je einem Wert von mindestens einem Parameter ausgewählt aus der Länge, Breite und Höhe des Substratträgers bei einer bekannten ersten Temperatur. Die erste Vorrichtung kann bspw. mechanische, optische, elektrische oder magnetische Sensoren aufweisen, mit denen das erste Parameterset ermittelt werden kann. Die zweite Vorrichtung ist zum Ermitteln der Positionen eines Bezugspunktes des Substratträgers, des mindestens einen Substratbezugspunktes auf dem Substratträger und der Vorrichtung zum Greifen oder Positionieren in einem gemeinsamen räumlichen Koordinatensystem bei der ersten Temperatur geeignet. Auch diese Vorrichtung kann wieder mechanische, optische oder andere Sensoren aufweisen, mit deren Hilfe die entsprechenden Positionen im Koordinatensystem bzw. die Relationen der einzelnen Positionen zueinander ermittelt werden können. Eine dritte Vorrichtung ist geeignet, den Substratträger an einer ersten Position im Koordinatensystem bei einer unbekannten zweiten Temperatur derart zu positionieren, dass der Bezugspunkt des Substratträgers an einer vorgegebenen Position in Bezug auf mindestens eine Richtung des Koordinatensystems angeordnet ist. Die vierte Vorrichtung dient zum Ermitteln eines zweiten Parametersets aus Werten für gleichartige Parameter wie das erste Parameterset des an der ersten Position positionierten Substratträgers bei der zweiten Temperatur des Substratträgers. Die vierte Vorrichtung enthält mindestens zwei Lasersensoren zum Ermitteln des Wertes für mindestens einen Parameter, die auf gegenüberliegenden Seiten des Substratträgers und auf einer Laserlinie angeordnet sind. Eine fünfte Vorrichtung ist geeignet, die Position des mindestens einen Substratbezugspunktes des an der ersten Position positionierten Substratträgers im Koordinatensystem mindestens bezüglich der ersten Richtung zu ermitteln. Dies geschieht mit Hilfe des ersten Parametersets und des zweiten Parametersets sowie der in der zweiten Vorrichtung ermittelten Positionen des Bezugspunktes des Substratträgers und des mindestens einen Substratbezugspunktes unter Einbeziehung des mindestens einen Ausdehnungskoeffizienten des Materials des Substratträgers. Eine sechste Vorrichtung dient letztlich zur Erstellung und Übertragung von Steuersignalen an die Vorrichtung zum Greifen oder Positionieren in Abhängigkeit von der in der fünften Vorrichtung ermittelten Position des mindestens einen Substratbezugspunktes.

Vorzugsweise enthält die vierte Vorrichtung mindestens drei Lasersensoren zum Ermitteln des Wertes für mindestens einen Parameter. Damit ist die vierte Vorrichtung geeignet, eine Verdrehung des Substratträges gegenüber den mit der zweiten Vorrichtung ermittelten Positionen des Bezugspunktes des Substratträgers und des mindestens einen Substratbezugspunktes zu erkennen und zu ermitteln. In besonders bevorzugter Weise ist mindestens ein Lasersensor nicht auf einer Laserlinie mit zwei anderen der mindestens drei Lasersensoren, jedoch auf derselben Seite des Substratträgers wie einer dieser zwei anderen Lasersensoren angeordnet.

Die dritte Vorrichtung enthält vorzugsweise einen mechanischen Anschlag oder einen elektrischen, magnetischen oder optischen Sensor zum Positionieren des Substratträgers an der ersten Position.

In einer spezifischen Ausführungsform enthält die fünfte Vorrichtung mindestens eine Wertetabelle oder mindestens eine Kennlinie, in der der mit der vierten Vorrichtung ermittelte Wert des mindestens einen Parameters des zweiten Parametersets in Bezug zu dem Wert des gleichartigen Parameters des ersten Parametersets, zu den in der zweiten Vorrichtung ermittelten Positionen des Bezugspunktes des Substratträgers und des mindestens einen Substratbezugspunktes sowie zu der in der dritten Vorrichtung eingestellten Position des Bezugspunktes des Substratträgers und zu der zu ermittelnden Position des mindestens einen Substratbezugspunktes bei der zweiten Temperatur gesetzt ist. Die Wertetabelle oder Kennlinie ist mit geeigneten Mitteln, wie bspw. optischen oder mechanischen Sensoren erstellt worden, bevor das erfindungsgemäße Verfahren zum ersten Mal zum Greifen oder Positionieren von mindestens einem Substrat von bzw. auf dem Substratträger bei der zweiten Temperatur genutzt wird.

In einer anderen bevorzugten Ausführungsform enthält die fünfte Vorrichtung eine Recheneinheit, die geeignet ist, die Position des mindestens einen Substratbezugspunktes des an der ersten Position positionierten Substratträgers im Koordinatensystem mindestens bezüglich der ersten Richtung mit Hilfe des ersten Parametersets und des zweiten Parametersets sowie der in der zweiten Vorrichtung ermittelten Positionen des Bezugspunktes des Substratträgers und des mindestens einen Substratbezugspunktes unter Einbeziehung des mindestens einen Ausdehnungskoeffizienten des Materials des Substratträgers zu berechnen.

Vorteilhafterweise ist die fünfte Vorrichtung darüber hinaus geeignet, die zweite Temperatur des Substratträgers mit Hilfe des ersten Parametersets und des zweiten Parametersets des Substratträgers unter Einbeziehung des mindestens einen Ausdehnungskoeffizienten des Materials des Substratträgers zu ermitteln. Des Weiteren ist die sechste Vorrichtung vorteilhafterweise geeignet, Steuersignale für eine Vorrichtung zur Steuerung einer Heizeinrichtung in einer Kammer in Abhängigkeit von der in der fünften Vorrichtung ermittelten zweiten Temperatur zu erstellen und an diese zu übertragen. Die Kammer ist für das Bearbeiten, d.h. das Erzeugen oder Entfernen von Schichten auf bzw. von dem mindestens einen Substrat, Inspizieren, Transportieren, Positionieren, Heizen bzw. Kühlen oder Schleusen des mindestens einen Substrats geeignet. Vorzugsweise ist diese Kammer eine Kammer, in der die erste Position des Substratträgers angeordnet ist, oder eine Kammer unmittelbar vor oder hinter einer solchen Kammer entlang der Prozesslinie eines Substrates.

Vorzugweise weist die erste Vorrichtung gleichartige Lasersensoren zum Ermitteln des ersten Parametersets auf wie die vierte Vorrichtung. Damit ist eine Erhöhung der Genauigkeit der Positionsermittlung des mindestens einen Substratbezugspunktes in der fünften Vorrichtung erreichbar.

Nachfolgend wird die Erfindung anhand der Figuren näher erläutert. Es zeigen:

| | |
|---|---|
| Fig. 1 | eine schematische Draufsicht auf eine erste Ausführungsform eines Substratträgers für mehrere Substrate sowie des Bezugspunktes des Substratträgers und der Substratbezugspunkte; |
| Fig. 2 | eine schematische Darstellung der Position des Bezugspunktes des Substratträgers und eines beispielhaften Substratbezugspunktes in einem räumlichen Koordinatensystem; |
| Fig. 3A und 3B | eine schematische Darstellung der Position des Bezugspunktes des Substratträgers und eines beispielhaften Substratbezugspunktes in einer Ebene des Koordinatensystems für zwei verschiedene Temperaturen; |
| Fig. 4 | einen schematischen Querschnitt durch eine Vorrichtung zum Greifen oder Positionieren und einen Substratträger mit darauf angeordneten Substraten; |
| Fig. 5 | eine schematische Darstellung einer Prozesslinie eines Substrates; |
| Fig. 6 | eine schematische Darstellung einer Ausführungsform des erfindungsgemäßen Verfahrens zum Steuern einer Vorrichtung zum Greifen oder Positionieren; |
| Fig. 7 | eine schematische Darstellung einer Ausführungsform des erfindungsgemäßen Systems zum Steuern einer Vorrichtung zum Greifen oder Positionieren; |
| Fig. 8 | eine schematische Ansicht der Seitenfläche eines Substratträgers mit einer Aussparung zur Positionierung des Substratträgers an einer ersten Position; |
| Fig. 9 | eine schematische Ansicht einer Ausführungsform der Vorrichtung zur Ermittlung des zweiten Parametersets mit zwei Lasersensoren, und |
| Fig. 10 | eine schematische Ansicht einer Ausführungsform der Vorrichtung zur Ermittlung des zweiten Parametersets mit drei Lasersensoren. |

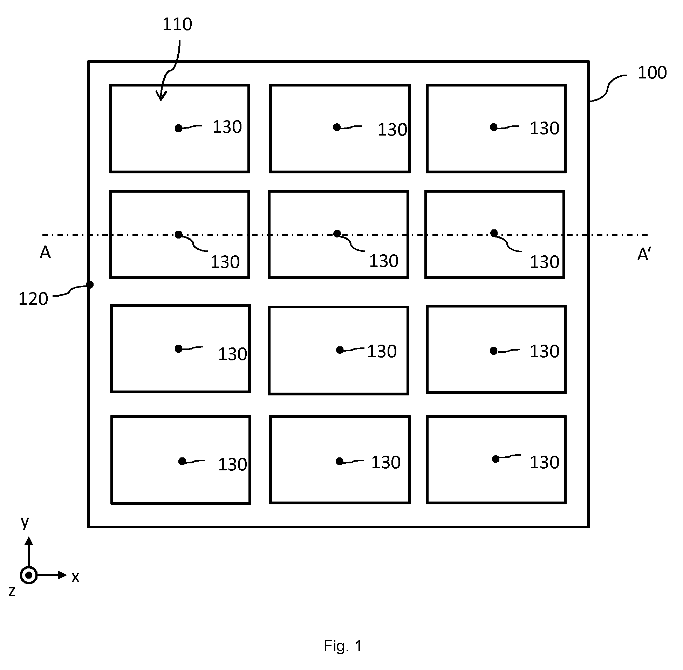

In **Figur 1** ist schematisch eine erste Ausführungsform eines Substratträgers 100 in einer Draufsicht auf eine x-y-Ebene dargestellt. Der Substratträger 100 kann eine beliebige äußere Form haben, bspw. rund, viereckig oder mehreckig sein, und weist Vertiefungen oder Durchbrüche 110 auf, die zur Aufnahme von Substraten geeignet sind. In anderen Ausführungsformen des Substratträgers können jedoch statt der Vertiefungen auch andere Mittel zur Aufnahme und Fixierung der Substrate auf dem Substratträger vorhanden sein. Bspw können in oder auf der Oberfläche des Substratträgers Auskragungen, z.B. hohle oder volle, zylinder-, prismen-, kegel- oder pyramidenförmige Stifte (pins), ausgebildet sein, die eine Position eines Substrates auf dem Substratträger definieren und ein Verrutschen des Substrates auf der Substratoberfläche verhindern. Der in Fig. 1 dargestellte Substratträger 100 hat eine rechteckige Form und enthält zwölf Vertiefungen 110, die in vier Reihen entlang der y-Richtung und in drei Spalten entlang der x-Richtung angeordnet sind. Der Substratträger 100 weist einen Bezugspunkt 120 auf, der die Position des Substratträgers 100 in einem räumlichen x-y-z-Koordinatensystem mit orthogonalen Koordinatenachsen beschreibt. Der Substratträger 100 kann so positioniert werden, dass mindestens eine Koordinate des Bezugspunktes 120 bekannt ist. Darüber hinaus sind auf dem Substratträger 110 Substratbezugspunkte 130 angeordnet, wobei jedem Durchbruch 110 und damit jedem Substrat ein spezifischer Substratbezugspunkt 130 zugeordnet ist. Jedoch können auch mehr oder weniger Substratbezugspunkte 130 definiert sein. Sowohl der Bezugspunkt 120, als auch die Substratbezugspunkte 130 können nur virtuell ausgebildet sein, d.h. sie sind nicht als Kerben, Vertiefungen, Markierungen etc. auf dem Substratträger 100 angeordnet, sondern nur in einer virtuellen Beschreibung des Substratträgers 100, z.B. auf einem Speichermedium, abgelegt. Daher können die Substratbezugspunkte 130 bspw. jeweils der Mittelpunkt oder ein Eckpunkt der Durchbrüche 110 sein, während der Bezugspunkt 120 des Substratträgers bspw. ein Punkt auf der Oberseite des Substratträgers 100 an einer Seite des Substratträgers 100, ein Eckpunkt des Substratträgers 100 oder auch der Mittelpunkt des Substratträgers 100 oder ein anderer beliebiger Punkt sein kann.

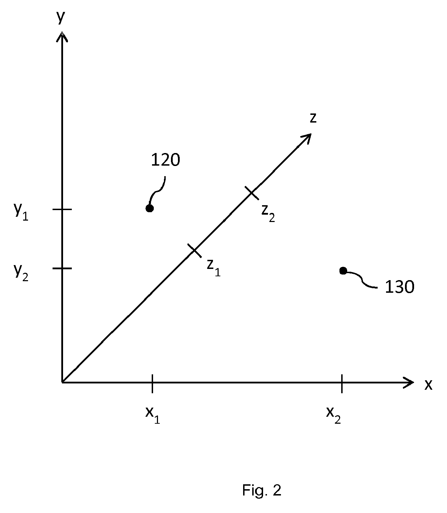

Mit Bezug auf die **Figur 2** soll die Anordnung des Bezugspunktes 120 des Substratträgers 100 und eines spezifischen Substratbezugspunktes 130 noch einmal erläutert werden. Dazu sind beide Punkte in dem gemeinsamen räumlichen x-y-z-Koordinatensystem gezeigt. Der Bezugspunkt 120 ist dabei durch die Koordinaten $(x_1, y_1, z_1)$ definiert, während der Substratbezugspunkt 130 die Koordinaten $(x_2, y_2, z_2)$ aufweist. Im dargestellten Fall sind alle Koordinaten der beiden Punkte verschieden voneinander, jedoch können auch einer oder mehrere oder alle der Koordinaten der beiden Punkte gleich sein.

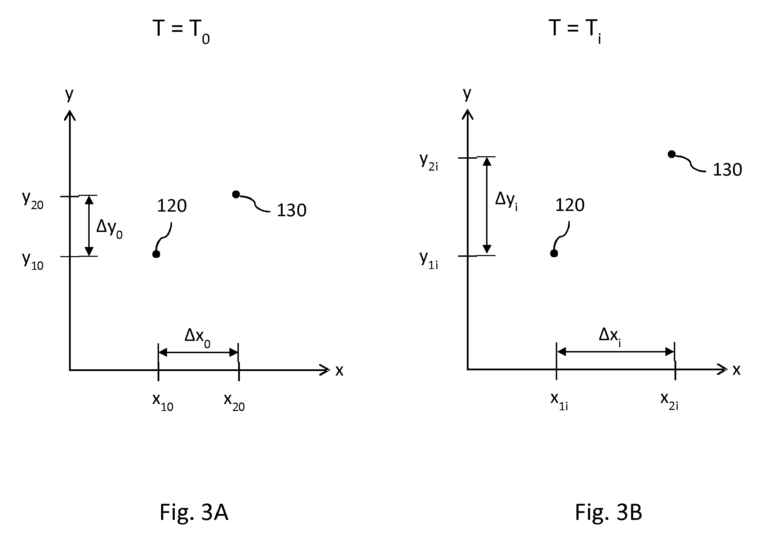

Die **Figuren 3A und 3B** zeigen die Position der beiden Punkte in einer x-y-Ebene des Koordinatensystems für zwei verschiedene Temperaturen $T_0$ und $T_i$. Dabei weisen der Bezugspunkt 120 und der Substratbezugspunkt 130 bei einer Kalibrierungstemperatur $T_0$ die Koordinaten $(x_{10}, y_{10})$ bzw. $(x_{20}, y_{20})$ auf, wie dies in Fig. 3A dargestellt ist. Entlang der x-Achse beträgt der Abstand zwischen den Punkten 120 und 130 $\Delta x_0$ und entlang der y-Achse $\Delta y_0$. Damit können die Koordinaten $(x_{20}, y_{20})$ des Substratbezugspunktes 130 wie folgt berechnet werden:

$$x_{20} = x_{10} + \Delta x_0 \qquad\qquad (1)$$

$$y_{20} = y_{10} + \Delta y_0 \qquad\qquad (2).$$

Auf ähnliche Weise stehen auch die Koordinaten $z_{10}$ und $z_{20}$ der beiden Punkte miteinander in Beziehung.

Bei einer anderen Temperatur $T_i$, die von der Kalibrierungstemperatur $T_0$ im in der Fig. 3B dargestellten Fall verschieden ist, weisen die beiden Punkte 120 und 130 die Koordinaten $(x_{1i}, y_{1i})$ bzw. $(x_{2i}, y_{2i})$ auf. Hier beträgt der Abstand zwischen den beiden Punkte 120 und 130 entlang der x-Achse $\Delta x_i$ und entlang der y-Achse $\Delta y_i$, so dass die Koordinaten $(x_{2i}, y_{2i})$ des Substratbezugspunktes 130 wie folgt berechnet werden können:

$$x_{2i} = x_{1i} + \Delta x_i \qquad\qquad (3)$$

$$y_{2i} = y_{1i} + \Delta y_i \qquad\qquad (4).$$

Da beide Punkte 120 und 130 bezüglich ihrer Position auf dem Substratträger 110 definiert sind, können die Abstände $\Delta x_i$ und $\Delta y_i$ bei bekannten Ausdehnungskoeffizienten $\alpha_x$ und $\alpha_y$ des Materials des Substratträgers 110 in x- bzw. y-Richtung und bekannten Temperaturen $T_0$ und $T_i$ wie folgt berechnet werden:

$$\Delta x_i = \Delta x_0 + \Delta x_0 \bullet \alpha_x \bullet (T_i - T_0) \qquad\qquad (5)$$

$$\Delta y_i = \Delta y_0 + \Delta y_0 \bullet \alpha_y \bullet (T_i - T_0) \qquad\qquad (6).$$

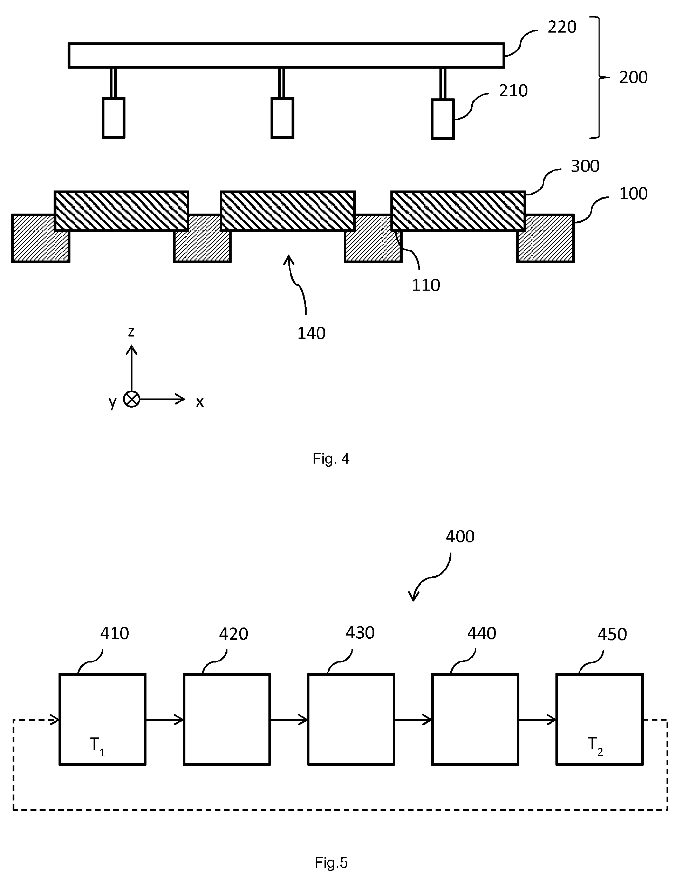

Mit Bezug auf **Figur 4** wird die Positionierung einer Vorrichtung 200 zum Greifen oder Positionieren bezüglich eines Substratträgers 110 mit darauf angeordneten Substraten 300 erläutert. Dazu zeigt die Fig. 4 einen Querschnitt durch den Substratträger 100 entlang der in Fig. 1 dargestellten Linie A-A' mit darauf angeordneten Substraten 300 und durch die Vorrichtung 200. Im Substratträger 100 sind die Vertiefungen 110, in denen die Substrate 300 auf dem Substratträger 100 aufliegen, sowie Durchbrüche 140 durch den Substratträger 100 ausgebildet. Die Substrate 300 können mit Hilfe der Vorrichtung 200 zum Greifen oder Positionieren von dem Substratträger 100 entfernt oder auf diesem definiert abgelegt, d.h. positioniert, werden. Dazu weist die Vorrichtung 200 im dargestellten Fall je eine Einrichtung 210 zum Greifen, bspw. einen Saugkopf, für jedes der Substrate 300 auf, die in einer Linie entlang der x-Richtung angeordnet sind. Damit können alle diese Substrate 300 gleichzeitig vom Substratträger 100 entfernt oder auf diesem abgelegt werden kann. Die einzelnen Einrichtungen 210 sind auf einem gemeinsamen Träger 220 angeordnet und können auf diesem beliebig entlang der x-Richtung verschoben, d.h. positioniert, werden. Der gesamte Träger 220 kann entlang der y-Richtung und der z-Richtung und ggf. auch entlang der x-Richtung bewegt werden, so dass die Einrichtungen 210 zum Greifen an einer bestimmten Position bezüglich der Substratbezugspunkte 130 im Koordinatensystem angeordnet werden und nacheinander die Substrate 300 jeweils einer Zeile des Substratträgers 100 entfernen oder positionieren können. Selbstverständlich kann die Vorrichtung 200 zum Greifen oder Positionieren auch anders ausgestaltet sein. Bspw. kann sie auch nur eine Einrichtung 210, die beliebig in x-, y- und z-Richtung positionierbar ist, oder genau so viele Einrichtungen 210, wie Substrate 300 auf dem Substratträger 100 angeordnet werden können, aufweisen.

In **Figur 5** ist schematisch eine Prozesslinie 400 zur Bearbeitung von Substraten dargestellt. Dabei werden in einer ersten Einheit 410 der Substratträger bereitgestellt und die Substrate mit Hilfe einer ersten Vorrichtung zum Greifen oder Positionieren auf dem Substratträger angeordnet. Dies geschieht bei einer Temperatur $T_1$ des Substratträgers. Danach werden in einer zweiten bis vierten Einheit 420 bis 440 die Substrate bearbeitet, bspw. werden Schichten auf mindestens jeweils einer Oberfläche der Substrate aufgebracht oder in den Substratoberflächen Strukturen erzeugt. Auch Zwischenschritte, wie das Erzeugen spezifischer Umgebungsbedingen, z.B. eines Vakuums, oder das Heizen oder Abkühlen der Substrate, können in den Einheiten 420 bis 440 ausgeführt werden. Innerhalb dieser Einheiten 420 bis 440 können der Substratträger und die Substrate bei verschiedenen Temperaturen behandelt werden. Dabei kann es zu Schwankungen in der Temperatur kommen. In einer fünften Einheit 450 werden die Substrate durch die erste oder eine zweite Vorrichtung zum Greifen oder Positionieren wieder von dem Substratträger entfernt. Mit anderen Worten: Die Vorrichtung zum Greifen oder Positionieren, mit deren Hilfe in der fünften Einheit 450 die Substrate von dem Substratträger entfernt werden, kann die selbe Vorrichtung zum Greifen oder Positionieren sein, wie diejenige, welche in der ersten Einheit 410 zum Anordnen der Substrate auf dem Substratträger genutzt wurde. Jedoch können auch zwei separate Vorrichtungen zum Greifen oder Positionieren in der ersten Einheit 410 und der zweiten Einheit 450 eingesetzt werden. Das Entfernen der Substrate von dem Substratträger geschieht nun bei einer Temperatur $T_2$ des Substratträgers. Selbstverständlich können mehr oder weniger Bearbeitungseinheiten zwischen der ersten Einheit 410 und der fünften Einheit 450 angeordnet sein, als die in Fig. 5 dargestellten drei Einheiten 420 bis 440. Der Substratträger wird im Allgemeinen nach dem Entfernen der bearbeiteten Substrate in der fünften Einheit 450 wieder der ersten Einheit 410 zugeführt, so dass neue Substrate darauf positioniert werden können. Diese Rückführung des Substratträgers ist in Fig. 5 durch die gestrichelte Linie gekennzeichnet. Damit ist die erste Einheit 410 eine in der Prozesslinie bezüglich des Substratträgers nach der fünften Einheit 450 angeordnete Einheit, während die vierte Einheit 440 eine vor der fünften Einheit 450 angeordnete Einheit ist. Sowohl die Temperatur $T_2$ als auch die Temperatur $T_1$, insbesondere bei einer Rückführung des Substratträgers von der fünften Einheit 450 zur ersten Einheit 410, können unbekannt sein und auch über die Zeit bzw. für unterschiedliche Substratträger variieren. Damit stellt die Steuerung der Vorrichtungen zum Greifen und Positionieren in den Einheiten 410 und 450 eine besondere Herausforderung dar.

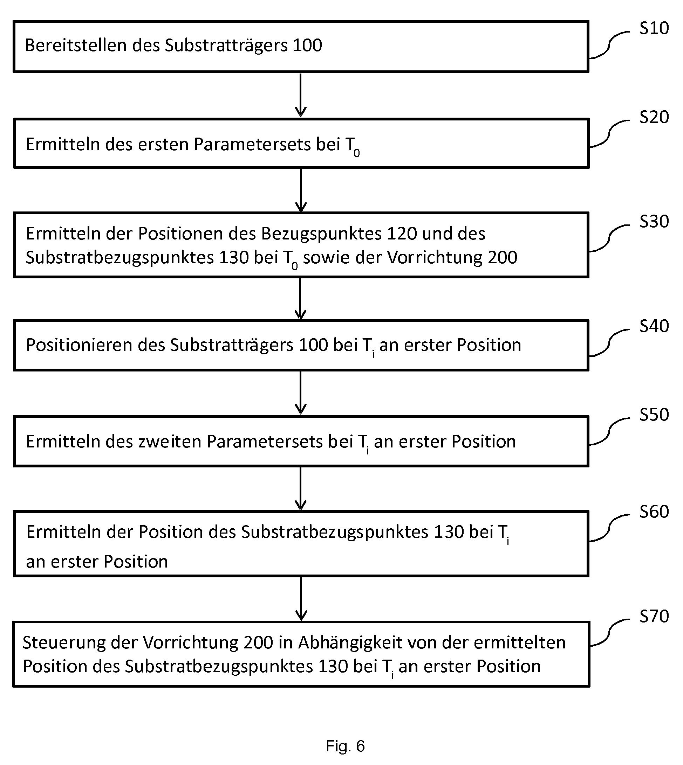

**Figur 6** zeigt eine schematische Darstellung einer Ausführungsform des erfindungsgemäßen Verfahrens zum Steuern einer Vorrichtung 200 zum Greifen oder Positionieren, die in den in Figur 5 dargestellten Einheiten 410 und 450 zum Einsatz kommt. In einem ersten Schritt S10 wird der Substratträger 100 bereitgestellt. Dabei ist der Substratträger 100 geeignet, mindestens ein Substrat 300 aufzunehmen. Von dem Substratträger 100 sind der oder die Ausdehnungskoeffizienten αn für alle Richtungen eines Koordinatensystems bekannt. In einem zweiten Schritt S20 wird ein erstes Parameterset des Substratträgers 100 bei einer ersten Temperatur, der Kalibrierungstemperatur $T_0$, ermittelt. Die Kalibrierungstemperatur $T_0$ ist bekannt. Das erste Parameterset enthält mindestens den Wert $L_0$ für die Ausdehnung des Substratträgers 100 in x-Richtung, nachfolgend Länge genannt. Vorzugsweise enthält das Parameterset auch die Werte $B_0$ und $H_0$ für die Ausdehnung des Substratträgers 100 in y- und z-Richtung, nachfolgend Breite und Höhe genannt. Im Schritt S30 werden bei der Kalibrierungstemperatur $T_0$ die Positionen des Bezugspunktes 120 des Substratträgers 100 und der Substratbezugspunkte 130 im x-y-z-Koordinatensystem, d.h. die Koordinaten $(x_{10}, y_{10}, z_{10})$ für den Bezugspunkt 120 und die Koordinaten $(x_{20}, y_{20}, z_{20})$ für einen spezifischen Substratbezugspunkt 130, ermittelt. Dies kann bspw. mittels einer Kamera oder eines anderen geeigneten Mittels geschehen. Darüber hinaus wird im Schritt S30 die Position der Vorrichtung 200 im x-y-z-Koordinatensystem ermittelt, die die Ausgangsposition der Vorrichtung 200 für die spätere Steuerung der Vorrichtung 200 darstellt. Die Schritte S20 und S30 stellen Kalibrierungsschritte dar und können in einer beliebigen Reihenfolge und nur einmalig in dem erfindungsgemäßen Verfahren ausgeführt werden. Jedoch können sie auch für verschiedene Temperaturen, die jedoch alle bekannt sind, ausgeführt werden, um die Genauigkeit der Steuerung der Ermittlung der Positionen der Substratbezugspunkte 130 bei einer unbekannten Temperatur und damit die Genauigkeit der Steuerung der Vorrichtung 200 zu erhöhen. Auch ein mehrmaliges Ausführen der Schritte S20 und S30 zu verschiedenen Zeitpunkten, bspw. nach 10 Durchläufen des Substratträgers 100 durch eine bestimmte Prozesslinie, kann vorteilhaft sein, um Änderungen des ersten Parametersets über die Zeit zu berücksichtigen. Solche Änderungen des ersten Parametersets können bspw. durch Beschichtungen auf dem Substratträger 100 oder durch das Entfernen von Material des Substratträgers 100 über einen längeren Zeitraum auftreten. Darüber hinaus können mit einer Ermittlung des ersten Parametersets von Zeit zu Zeit auch Drifterscheinungen der verwendeten Messmittel, z.B. Lasersensoren, erkannt und ggf. eliminiert werden. Dies ist besonders dann von Vorteil, wenn dieselben oder gleichartige Messmittel auch zur Ermittlung des zweiten Parametersets verwenden werden.

Nach diesen Schritten wird der Substratträger 100, der nun eine unbekannte Temperatur T aufweist, im Schritt S40 in einer Einheit der Prozesslinie, bspw. der ersten Einheit 410 oder der fünften Einheit 450, an einer ersten Position im x-y-z-Koordinatensystem so positioniert, dass mindestens eine Koordinate des Bezugspunktes 120 des Substratträgers 100 einer vorgegebenen Position entspricht und damit bekannt ist. Bspw. kann der Substratträger 100 mittels einer an einer Seitenfläche des Substratträgers 100 angebrachten Marke und eines Sensors, der diese Marke erkennt, bezüglich der y-Richtung genau positioniert werden, so dass die Koordinate $y_{1i}$ bekannt ist. Eine oder beide der beiden anderen Koordinaten $x_{1i}$ und $z_{1i}$ des Bezugspunktes 120 können ebenfalls einer vorgegebenen Position entsprechen und damit bekannt sein, können aber auch unbekannt sein. Die unbekannte Temperatur T, die bspw. die Temperatur $T_1$ oder die Temperatur $T_2$ aus Fig. 5 sein kann, ist aufgrund der Umgebungs- und Randbedingungen an der ersten Position, z.B. Vorliegen von reaktiven Gasbestandteilen oder eines Vakuums, nicht direkt messbar. Darüber hinaus können auch die Positionen der Substratbezugspunkte 130 aufgrund der Umgebungs- und Randbedingungen an der ersten Position nicht direkt bzw. unmittelbar mittels eines Sensors, bspw. eines optischen Sensors, ermittelt werden. So kann eine direkte Positionsermittlung bei den an der ersten Position des Substratträgers vorliegenden Umgebungs- und Randbedingungen unmöglich oder unvorteilhaft sein, da bspw. die vorliegende Temperatur $T_i$, hochreaktive Prozessgase in der Umgebungsatmosphäre, elektromagnetische Felder sowie ein mangelndes Platzangebot die Nutzung eines solchen Sensors zur Ermittlung der Position der Substratbezugspunkte 130 nicht erlauben. Insbesondere bei der Notwendigkeit zur Ermittlung der Position einer Vielzahl von Substratbezugspunkten 130 kann auch die Zeit für eine direkte Ermittlung dieser Positionen nicht ausreichend sein. Daher ist die Ermittlung dieser Positionen mit Hilfe einer anderen Methode notwendig.

Dazu wird erfindungsgemäß in Schritt S50 ein zweites Parameterset des Substratträgers 100 an der ersten Position des Substratträgers 100 bei der Temperatur T ermittelt, wobei das zweite Parameterset mindestens einen Wert für einen gleichartigen Parameter wie das erste Parameterset aufweist. D.h., wenn das erste Parameterset die Länge $L_0$, die Breite $B_0$ und die Höhe $H_0$ enthält, dann enthält das zweite Parameterset mindestens die Länge $L_i$ oder die Breite Bi oder die Höhe $H_i$, kann aber auch zwei oder alle Parameter L, Bi und $H_i$ enthalten. Der mindestens eine Parameterwert des zweiten Parametersets wird mit Hilfe von mindestens zwei Lasersensoren, die auf gegenüberliegenden Seiten des Substratträgers 100 und auf einer Laserlinie positioniert sind, ermittelt.

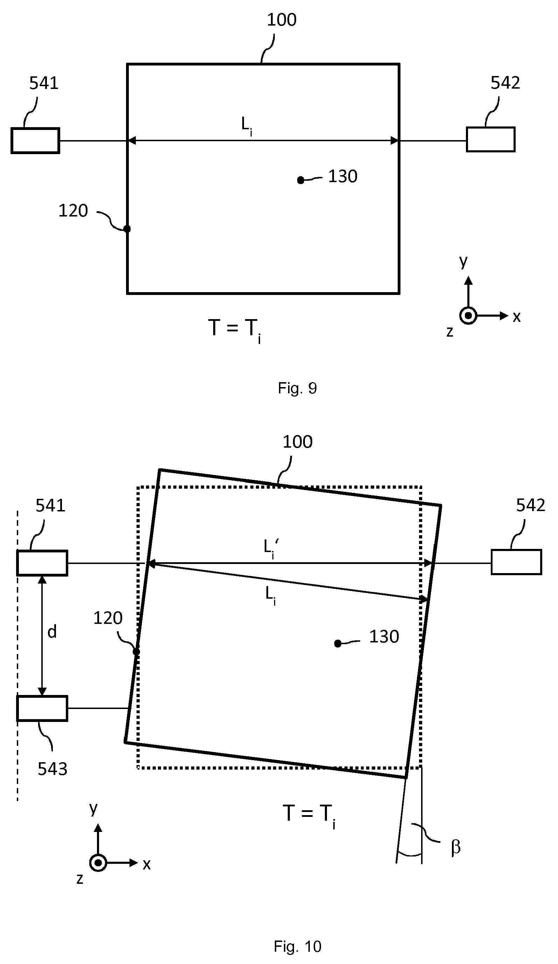

In Schritt S60 werden anschließend die Positionen der Substratbezugspunkte 130 mit Hilfe des ersten Parametersets und des zweiten Parametersets sowie mit Hife der in Schritt S30 ermittelten Positionen des Bezugspunktes 120 und der Substratbezugspunkte 130 und der bekannten Ausdehnungskoeffizienten $\alpha n$ ausgehend von der bekannten mindestens einen Koordinate $y_{1i}$ ermittelt. Dabei kann jedoch die Position der Substratbezugspunkte 130 nur in Bezug auf die Richtung des Koordinatensystems genau ermittelt werden, in die auch die erste Position des Substratträgers 100 genau definiert ist. Mit anderen Worten: Ist die erste Position des Substratträgers 100 genau in y-Richtung definiert und damit die Koordinate $y_{1i}$ des Bezugspunktes 120 bekannt, so kann damit die genaue Position der Substratbezugspunkte 130 in y-Richtung, also die Koordinate $y_{2i}$ für jeden Substratbezugspunkt 130 ermittelt werden. Kann die Position des Bezugspunktes 120 an der ersten Position des Substratträgers 100 auch bezüglich der anderen Koordinaten $x_{1i}$ und $z_{1i}$ genau definiert werden, z.B. weil der Bezugspunkt 120 an einer unteren Kante des Substratträgers 100 angeordnet und die Unterseite des Substratträgers 100 sowie die an den Bezugspunkt 120 angrenzende Seitenfläche des Substratträgers 100 an der ersten Position des Substratträgers 100 genau definiert angeordnet sind, dann können auch alle Koordinaten der Substratbezugspunkte 130 an der ersten Position des Substratträgers 100 exakt ermittelt werden. Ein Bespiel für eine Berechnung der Koordinate $y_{2i}$ wird mit Bezug auf Fig. 9 gegeben.

Werden zur Ermittlung des ersten und des zweiten Parametersets ein und dieselben Messmittel, z.B. in oder an ein und derselben Vakuumkammer angeordnete Lasersensoren, benutzt, so sollten die Umgebungsbedingungen, unter denen die Ermittlung der Parametersets erfolgt, möglichst weitgehend gleich sein, ausgenommen die Temperatur des Substratträgers. Dies soll an folgendem Beispiel verdeutlicht werden: Das erste Parameterset und das zweite Parameterset werden mit Hilfe von Lasersensoren, die in oder an der Wand einer Vakuumkammer befestigt sind, ermittelt. Liegt zum Zeitpunkt der Ermittlung des zweiten Parametersets bspw. ein Vakuum, d.h. ein verringerter Druck, in der Vakuumkammer vor, dann sollte dies auch zum Zeitpunkt der Ermittlung des ersten Parametersets gegeben sein. Die Lage der Wand einer Vakuumkammer kann sich bspw. um mehrere mm verschieben zwischen dem Vorliegen eines Normaldrucks in der Vakuumkammer und dem Vorliegen eines Vakuums in der Vakuumkammer. Damit bewegen sich auch die Lasersensoren um diesen Betrag, so dass eine Ermittlung des ersten Parametersets bei Normaldruck und die Ermittlung des zweiten Parametersets bei Vakuum keine genaue Ermittlung der Position eines Substratbezugspunktes bei der unbekannten Temperatur $T_i$ ermöglicht. Daher sollte auch das erste Parameterset bereits bei Vakuum ermittelt werden.

In Schritt S70 wird schließlich die Vorrichtung 200 zum Greifen oder Positionieren in Abhängigkeit von den in Schritt S60 ermittelten Koordinaten der Substratbezugspunkte 130 gesteuert. Dabei können die Einrichtungen 210 zum Greifen insbesondere in die Richtung des Koordinatensystems, in die die Position des Bezugspunktes 120 an der ersten Position des Substratträgers 100 genau definiert ist, z.B. in y-Richtung, sehr genau positioniert werden.

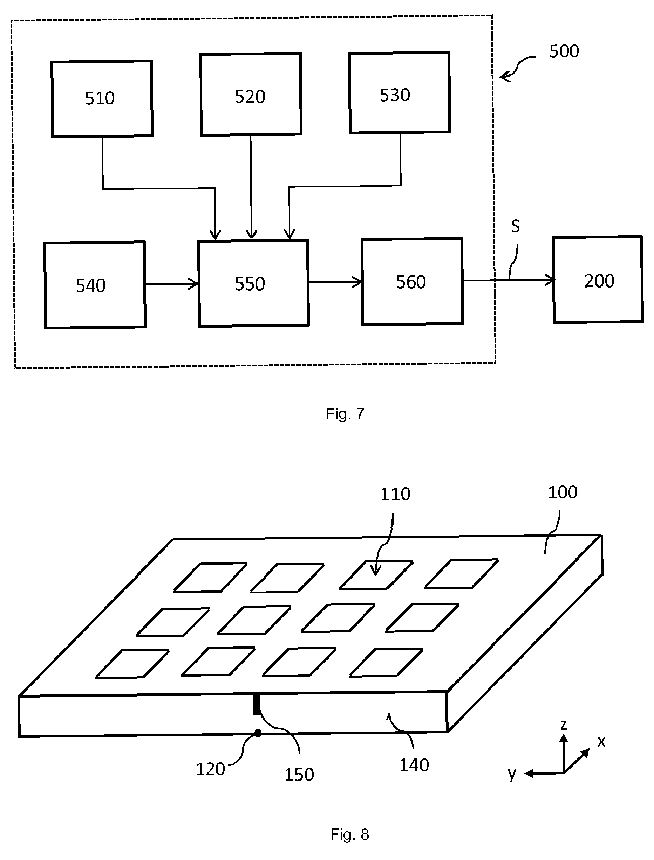

**Figur 7** zeigt eine schematische Darstellung einer Ausführungsform des erfindungsgemäßen Systems 500 zum Steuern einer Vorrichtung 200 zum Greifen oder Positionieren. Das System 500 enthält eine erste Vorrichtung 510 zum Ermitteln des ersten Parametersets bei der Temperatur $T_0$ sowie eine zweite Vorrichtung 520 zum Ermitteln der Positionen des Bezugspunktes und der Substratbezugspunkte bei der Temperatur $T_0$. Die zweite Vorrichtung 520 ist auch geeignet, die Position der Vorrichtung 200 im gemeinsamen Koordinatensystem zu ermitteln. Eine dritte Vorrichtung 530 dient der Positionierung des Substratträgers an einer ersten Position bei einer unbekannten Temperatur $T_i$ derart, dass der Bezugspunkt des Substratträgers an einer vorgegebenen Position des Koordinatensystems angeordnet wird und damit zumindest eine Koordinate des Bezugspunktes genau definiert ist. Eine vierte Vorrichtung 540 ist geeignet, ein zweites Parameterset des Substratträgers an der ersten Position des Substratträgers bei der Temperatur $T_i$ zu ermitteln. Dabei weist die vierte Vorrichtung 540 mindestens zwei Lasersensoren auf, von denen zwei auf gegenüberliegenden Seiten des Substratträgers und auf einer Laserlinie angeordnet sind. Eine fünfte Vorrichtung 550 dient der Ermittlung der Position der Substratbezugspunkte an der ersten Position des Substratträgers bei der Temperatur $T_i$.

Dazu werden die in den ersten bis vierten Vorrichtungen 510 bis 540 ermittelten Werte sowie die bekannten Ausdehnungskoeffizienten des Materials des Substratträgers verarbeitet. In der sechsten Vorrichtung 560 werden schließlich in Abhängigkeit der in der fünften Vorrichtung 550 ermittelten Positionen der Substratbezugspunkte Steuersignale S für das Steuern der Vorrichtung 200 erstellt und an diese übertragen.

**Figur 8** zeigt eine schematische Ansicht des Substratträgers 100. Der Substratträger 100 weist eine Seitenfläche 140 mit einer Aussparung 150 zur Positionierung des Substratträgers 100 an der ersten Position auf. Die Aussparung 150 kann bspw. mittels eines optischen Sensors, z.B. eines Lasersensors, erkannt werden, so dass Motoren eines Transportmittels, das den Substratträger 100 im Koordinatensystem bewegt, derart gesteuert werden, dass der Substratträger 100 an einer ersten Position positioniert wird. Da sich die Seitenfläche 140 in y-Richtung erstreckt, wird also eine genaue Positionierung des Substratträgers 100 in y-richtung durch die Aussparung 150 in y-Richtung ermöglicht. Im in Fig. 8 dargestellten Fall ist der Bezugspunkt 120 an der Kante der Seitenfläche 140 zur Unterseite des Substratträgers 100 genau in der Mitte der Aussparung 150 angeordnet, so dass durch die Erkennung der Aussparung 150 und die Steuerung eines Transportmittels zum Bewegen des Substratträgers 100 mindestens die Koordinate $y_{1i}$ des Bezugspunktes 120 an der ersten Position des Substratträgers 100 bei der Temperatur $T_i$ genau definiert ist.

Mit Bezug auf die **Figur 9** soll die Ermittlung der Koordinate $y_{2i}$ erläutert werden. Die Figur 9 zeigt eine schematische Ansicht einer Ausführungsform der vierten Vorrichtung 540 zur Ermittlung des zweiten Parametersets. Zu sehen sind der Substratträger 100 sowie zwei Lasersensoren 541 und 542, die Bestandteil der vierten Vorrichtung 540 sind. Die Lasersensoren 541 und 542 sind bspw. Lasersensoren IL-100 der Firma Keyence, die mittels einer Auswertung der Laufzeit eines von der Seitenfläche des Substratträgers 100 reflektierten Laserstrahls den Abstand des Lasersensors zu der reflektierenden Seitenfläche ermitteln kann. Die Lasersensoren ermöglichen eine genaue Ermittlung eines Abstandes oder einer Ausdehnung eines Objektes in einem weiten Temperaturbereich und bei unterschiedlichen und auch für andere Messmethoden ungünstigen Umgebungsbedingungen. Die Lasersensoren 541 und 542 sind auf gegenüberliegenden Seiten des Substratträgers 100 bezüglich der x-Richtung und auf einer Laserlinie angeordnet, die entlang der x-Richtung verläuft. Damit kann mittels dieser beiden Lasersensoren die Länge $L_i$ des Substratträgers 100, also die Ausdehnung des Substratträgers 100 in x-Richtung, mit einer Auflösung von 2 $\mu$m auf eine Länge $L_i$ von ca. 1 m ermittelt werden. Aus den Parametern $y_{1i}$, $\Delta y_0$, $L_0$, $L_i$, $\alpha_x$ und $\alpha_y$ kann nun in der fünften Vorrichtung 550 mit den Formeln (4), (5) und (6) die Koordinate eines spezifischen Substratbezugspunktes 130 wie folgt berechnet werden:

$$y_{2i} = y_{1i} + \Delta y_i = y_{1i} + \Delta y_0 + \Delta y_0 \bullet \alpha_y \bullet (L_i - L_0) / (L_0 \bullet \alpha_x) \qquad (7).$$

**Figur 10** zeigt eine schematische Ansicht einer weiteren Ausführungsform der vierten Vorrichtung 540 zur Ermittlung des zweiten Parametersets, die neben den mit Bezug auf die Figur 9 beschriebenen Lasersensoren 541 und 542 einen dritten Lasersensor 543 derselben Bauart enthält. Der dritte Lasersensor 543 ist in der dargestellten Ausführungsform auf derselben Seite des Substratträgers 100 wie der Lasersensor 541 und in einem Abstand d entlang der y-Richtung von diesem angeordnet. Dabei sind die Positionen des ersten Lasersensors 541 und des dritten Lasersensors 543 bezüglich der x-Richtung bekannt. Im einfachsten Fall sind die beiden Lasersensoren 541 und 543 an derselben x-Position im Koordinatensystem angeordnet, wie dies durch die gestrichelte Linie gezeigt ist. Mit Hilfe des dritten Lasersensors 543 kann durch den Unterschied in der Laufzeit der reflektierten Laserstrahlen der beiden Lasersensoren 541 und 543 eine Verdrehung des Substratträgers 100 gegenüber einer korrekten Ausrichtung des Substratträgers 100 in der x-y-Ebene des Korrdinatensystem um einen Winkel β erkannt werden. Die korrekte Ausrichtung des Substratträgers 100 ist in Fig. 10 durch den gestrichelten Umriss des Substratträgers 100 dargestellt. Durch eine solche Verdrehung des Substratträgers wird mit Hilfe des ersten Lasersensors 541 und des zweiten Lasersensors 542 nicht die tatsächliche Längen des Substratträgers 100, sondern eine verfälschte Länge L' ermittelt. Jedoch kann aus die tatsächliche Länge $L_i$, aus der ermittelten Ausdehnung $L_i$' und dem Winkel β berechnet werden. Damit kann durch die Auswertung einer möglicherweise gegebenen Verdrehung des Substratträgers 100 kann sowohl die Genauigkeit der Bestimmung der Länge $L_i$ erhöht, als auch die Steuerung der Einrichtungen 210 zum Greifen in der Vorrichtung 200 entsprechend angepasst werden.

Neben der in Fig. 10 dargestellten Anordnung des dritten Lasersensors 543 auf derselben Seite des Substratträgers 100 wie der Lasersensor 541 kann der dritte Lasersensor 543 oder ein weiterer Lasersensor auch auf einer anderen Seite des Substratträgers 100, bspw. auf einer senkrecht zu der Seite des Substratträgers 100, auf der der erste Lasersensor 541 angeordnet ist, angeordnet und auf diese ausgerichtet sein. Bspw. kann auch ein Lasersensor auf einer Seite des Substratträgers 100, die bei korrekter Ausrichtung des Substratträgers 100 entlang der x-Richtung verlaufen würde, angeordnet und auf diese ausgerichtet sein. Das heißt, dieser Lasersensor würde bspw. einen Laserstrahl aussenden, der senkrecht zu den von den Lasersensoren 541 und 542 ausgesendeten Laserstrahlen verläuft. Auch mit einer solchen Anordnung lässt sich eine Verdrehung des Substratträgers 100 in der x-y-Ebene erkennen und berücksichtigen. Ebenfalls möglich ist die Anordnung eines Lasersensors derart, dass er auf die Substratoberfläche, in der die Vertiefungen oder Mittel zur Aufnahme der Substrate ausgebildet sind, ausgerichtet ist, wodurch eine Verkippung des Substratträgers im Raum, d.h. bezüglich einer x-y-Ebene erkannt und bei der Ermittlung der Substratbezugspunkte berücksichtigt werden kann.

Sind auch andere Koordinaten des Bezugspunktes 120 an der ersten Position des Substratträgers 100 bei der Temperatur Ti, also $x_{1i}$ und/oder $z_{1i}$, bekannt, können entsprechend auch die Koordinaten $x_{2i}$ und/oder $z_{2i}$ des spezifischen Substratbezugspunktes 130 berechnet werden:

$$x_{2i} = x_{1i} + \Delta x_i = x_{1i} + \Delta x_0 + \Delta x_0 \bullet (L_i - L_0) / L_0 \tag{8},$$

$$z_{2i} = z_{1i} + \Delta z_i = z_{1i} + \Delta z_0 + \Delta z_0 \bullet \alpha_z \bullet (L_i - L_0) / (L_0 \bullet \alpha_x) \tag{9}.$$

Zusätzlich kann aus den ermittelten ersten und zweiten Parametersets in der fünften Vorrichtung 550 die unbekannte Temperatur Ti gemäß der folgenden Formel berechnet werden:

$$T_i = T_0 + (L_i - L_0) / (L_0 \bullet \alpha_x) \tag{10}.$$

Es sind verschiedene Erweiterungen des erfindungsgemäßen Verfahrens und des erfindungsgemäßen Systems 500 möglich, um verschiedenste Ausführungsformen auszubilden, welche jedoch von einem Fachmann auf der Grundlage der hier dargestellten Ausführungsformen ohne Weiteres zu erkennen und zu implementieren sind.

Es sind verschiedene Erweiterungen des Verfahrens möglich, um verschiedenste Ausführungsformen des erfindungsgemäßen Verfahrens und des erfindungsgemäßen Systems bereit zu stellen, welche jedoch von einem Fachmann auf der Grundlage der hier dargestellten Ausführungsformen ohne Weiteres zu erkennen und zu implementieren sind.

**Bezugszeichen**

| 100 | Substratträger |
|---|---|
| 110 | Vertiefung |
| 120 | Bezugpunkt des Substratträgers |
| 130 | Substratbezugspunkt |
| 140 | Durchbruch |
| 200 | Vorrichtung zum Greifen oder Positionieren |
| 210 | Einrichtung zum Greifen |
| 220 | Träger |
| 300 | Substrat |
| 400 | Prozesslinie |
| 410 - 450 | erste bis fünfte Einheit |
| 500 | System zum Steuern einer Vorrichtung zum Greifen oder Positionieren |
| 510 | erste Vorrichtung zum Ermitteln des ersten Parametersets bei $T_0$ |
| 520 | zweite Vorrichtung zum Ermitteln Positionen bei $T_0$ |
| 530 | dritte Vorrichtung zum Positionieren des Substratträgers an erste Position bei Ti |
| 540 | vierte Vorrichtung zum Ermitteln des zweiten Parametersets bei T fünfte Vorrichtung zum Ermitteln der Position der Substratbezugspunkte bei |
| 550 | erster Position des Substratträgers und $T_i$ |
| 560 | sechste Vorrichtung zum Erstellen und Übertragen von Steuersignalen an die Vorrichtung zum Greifen und Positionieren |
| $T_0$ | Kalibrierungstemperatur des Substratträgers |
| $T_i$ | Temperatur des Substratträgers an erster Position |
| $\alpha_x, \alpha_y, \alpha_z$ | Ausdehnungskoeffizient des Substratträgermaterials in x-, y- bzw. z-Richtung |
| $x_{1n}, y_{1n}, z_{1n}$ | Koordinaten des Bezugspunktes des Substratträgers bei Temperatur $T_n$ |
| $x_{2n}, y_{2n}, z_{2n}$ | Koordinaten eine Substratbezugspunktes bei $T_n$ |
| S | Steuersignale für die Vorrichtung zum Greifen oder Positionieren |

**Patentansprüche**

1. Verfahren zur Steuerung einer Vorrichtung zum Greifen oder Positionieren von mindestens einem Substrat auf einem Substratträger mit den Schritten:

   a) Bereitstellen eines Substratträgers, der geeignet ist, mindestens ein Substrat zu tragen, und der aus einem Material mit mindestens einem bekannten Ausdehnungskoeffizienten besteht, und wobei die Position des mindestens einen Substrates auf dem Substratträger mittels mindestens eines Substratbezugspunktes definiert wird,
   b) Ermitteln eines ersten Parametersets des Substratträgers bestehend aus je einem Wert von mindestens einem Parameter ausgewählt aus der Länge, Breite und Höhe des Substratträgers bei einer bekannten ersten Temperatur des Substratträgers,
   c) Ermitteln der Positionen

   - eines Bezugspunktes des Substratträgers bei der ersten Temperatur des Substratträgers,
   - des mindestens einen Substratbezugspunktes auf dem Substratträger bei der ersten Temperatur des Substratträgers, und
   - der Vorrichtung zum Greifen oder Positionieren

   in einem gemeinsamen räumlichen Koordinatensystem,
   d) Positionieren des Substratträgers an einer ersten Position im Koordinatensystem bei einer unbekannten zweiten Temperatur derart, dass der Bezugspunkt des Substratträgers an einer vorgegebenen Position in Bezug auf mindestens eine erste Richtung des Koordinatensystems angeordnet ist,
   e) Ermitteln eines zweiten Parametersets aus Werten für gleichartige Parameter wie das erste Parameterset des an der ersten Position positionierten Substratträgers bei der zweiten Temperatur des Substratträgers, wobei mindestens ein Parameter mit Hilfe von mindestens zwei Lasersensoren ermittelt wird, wobei zwei der mindestens zwei Lasersensoren auf gegenüberliegenden Seiten des Substratträgers und auf einer Laserlinie angeordnet sind,
   f) Ermitteln der Position des mindestens einen Substratbezugspunktes des an der ersten Position positionierten Substratträgers im Koordinatensystem mindestens bezüglich der ersten Richtung mit Hilfe des ersten Parametersets und des zweiten Parametersets sowie der in Schritt c) ermittelten Positionen des mindestens einen Substratbezugspunktes und des Bezugspunkt des Substratträgers unter Einbeziehung des mindestens einen Ausdehnungskoeffizienten des Materials des Substratträgers und
   g) Steuerung der Vorrichtung zum Greifen oder Positionieren von mindestens einem Substrat in dem Koordinatensystem in Abhängigkeit von der in Schritt f) ermittelten Position des mindestens einen Substratbezugspunktes.

2. Verfahren nach Anspruch 1, **dadurch gekennzeichnet, dass**

   - in Schritt d) der Substratträger derart an der ersten Position positioniert wird, dass der Bezugspunkt des Substratträgers an einer vorgegebenen Position in Bezug auf alle Richtungen des Koordinatensystems angeordnet ist,
   - in Schritt f) die Position des mindestens einen Substratbezugspunktes bezüglich aller Richtungen des Koordinatensystems ermittelt wird.

3. Verfahren nach Anspruch 1 oder 2, **dadurch gekennzeichnet, dass**

   - in Schritt e) mindestens drei Lasersensoren zum Ermitteln des Wertes eines Parameters genutzt werden und
   - in Schritt f) bei der Ermittlung der Position des mindestens einen Substratbezugspunktes eine Verdrehung des Substratträgers gegenüber den in Schritt c) ermittelten Positionen durch die Auswertung der in Schritt e) gewonnenen Daten der mindestens drei Lasersensoren einbezogen wird.

4. Verfahren nach Anspruch 3, **dadurch gekennzeichnet, dass** mindestens einer der mindestens drei Lasersensoren nicht auf einer Laserlinie mit zwei anderen der mindestens drei Lasersensoren, jedoch auf derselben Seite des Substratträgers wie einer dieser zwei anderen Lasersensoren angeordnet ist.

5. Verfahren nach einem der vorherigen Ansprüche, **dadurch gekennzeichnet, dass** das Positionieren des Substratträgers an der ersten Position mit Hilfe eines mechanischen Anschlages oder eines elektrischen, magnetischen oder optischen Sensors erfolgt.

6. Verfahren nach einem der vorherigen Ansprüche, **dadurch gekennzeichnet, dass** in Schritt f) die zweite Temperatur des Substratträgers mit Hilfe des ersten Parametersets und des zweiten Parametersets des Substratträgers unter Einbeziehung des mindestens einen Ausdehnungskoeffizienten des Materials des Substratträgers ermittelt wird.

7. System zur Steuerung einer Vorrichtung zum Greifen oder Positionieren von mindestens einem Substrat auf einem Substratträger, bei dem die Position des mindestens einen Substrates auf dem Substratträger mittels mindestens eines Substratbezugspunktes definiert ist, mit

   a) einer ersten Vorrichtung zum Ermitteln eines ersten Parametersets des Substratträgers bestehend aus je einem Wert von mindestens einem Parameter ausgewählt aus der Länge, Breite und Höhe des Substratträgers bei einer bekannten ersten Temperatur,
   b) einer zweiten Vorrichtung zum Ermitteln der Positionen

   - eines Bezugspunktes des Substratträgers bei der ersten Temperatur,
   - des mindestens einen Substratbezugspunktes auf dem Substratträger bei der ersten Temperatur und
   - der Vorrichtung zum Greifen oder Positionieren
   in einem gemeinsamen räumlichen Koordinatensystem,

   c) einer dritten Vorrichtung zum Positionieren des Substratträgers an einer ersten Position im Koordinatensystem bei einer unbekannten zweiten Temperatur derart, dass der Bezugspunkt des Substratträgers an einer vorgegebenen Position in Bezug auf mindestens eine Richtung des Koordinatensystems angeordnet ist,
   d) einer vierten Vorrichtung zum Ermitteln eines zweiten Parametersets aus gleichartigen Parametern wie das erste Parameterset des an der ersten Position positionierten Substratträgers bei der zweiten Temperatur des Substratträgers, wobei die Vorrichtung mindestens zwei Lasersensoren zum Ermitteln des Wertes für mindestens einen Parameter enthält, wobei zwei der mindestens zwei Lasersensoren auf gegenüberliegenden Seiten des Substratträgers und auf einer Laserlinie angeordnet sind,
   e) einer fünften Vorrichtung zum Ermitteln der Position des mindestens einen Substratbezugspunktes des an der ersten Position positionierten Substratträgers im Koordinatensystem mindestens bezüglich der ersten Richtung mit Hilfe des ersten Parametersets und des zweiten Parametersets sowie der in der zweiten Vorrichtung ermittelten Positionen des Bezugspunktes des Substratträgers und des mindestens einen Substratbezugspunktes unter Einbeziehung des mindestens einen Ausdehnungskoeffizienten des Materials des Substratträgers und
   f) einer sechsten Vorrichtung zur Erstellung und Übertragung von Steuersignalen an die Vorrichtung zum Greifen oder Positionieren in Abhängigkeit von der in der fünften Vorrichtung ermittelten Position des mindestens einen Substratbezugspunktes.

8. System nach Anspruch 7, **dadurch gekennzeichnet, dass** die vierte Vorrichtung mindestens drei Lasersensoren zum Ermitteln des Wertes für mindestens einen Parameter enthält.

9. System nach Anspruch 8, **dadurch gekennzeichnet, dass** mindestens ein Lasersensor nicht auf einer Laserlinie mit zwei anderen der mindestens drei Lasersensoren, jedoch auf derselben Seite des Substratträgers wie einer dieser zwei anderen Lasersensoren angeordnet ist.

10. System nach einem der Ansprüche 7 bis 9, **dadurch gekennzeichnet, dass** die dritte Vorrichtung einen mechanischen Anschlag oder einen elektrischen, magnetischen oder optischen Sensor zum Positionieren des Substratträgers an der ersten Position enthält.

11. System nach einem der Ansprüche 7 bis 10, **dadurch gekennzeichnet, dass** die fünfte Vorrichtung mindestens eine Wertetabelle oder mindestens eine Kennlinie enthält, in der der mit der vierten Vorrichtung ermittelte Wert des mindestens einen Parameters des zweiten Parametersets in Bezug zu dem Wert des gleichartigen Parameters des ersten Parametersets, zu den in der zweiten Vorrichtung ermittelten Positionen des Bezugspunktes des Substratträgers und des mindestens einen Substratbezugspunktes sowie zu der in der dritten Vorrichtung eingestellten Position des Bezugspunktes des Substratträgers und zu der zu ermittelnden Position des mindestens einen Substratbezugspunktes bei der zweiten Temperatur gesetzt ist.

12. System nach einem der Ansprüche 7 bis 10, **dadurch gekennzeichnet, dass** die fünfte Vorrichtung eine Recheneinheit enthält, die geeignet ist, die Position des mindestens einen Substratbezugspunktes des an der ersten Position positionierten Substratträgers im Koordinatensystem mindestens bezüglich der ersten Richtung mit Hilfe des ersten Parametersets und des zweiten Parametersets sowie der in der zweiten Vorrichtung ermittelten Positionen des Bezugspunktes des Substratträgers und des mindestens einen Substratbezugspunktes unter Einbeziehung des mindestens einen Ausdehnungskoeffizienten des Materials des Substratträgers zu berechnen.

13. System nach einem der Ansprüche 7 bis 12, **dadurch gekennzeichnet, dass** die fünfte Vorrichtung geeignet ist, die zweite Temperatur des Substratträgers mit Hilfe des ersten Parametersets und des zweiten Parametersets des Substratträgers unter Einbeziehung des mindestens einen Ausdehnungskoeffizienten des Materials des Substratträgers zu ermitteln, und die sechste Vorrichtung geeignet ist, Steuersignale für eine Vorrichtung zur Steuerung einer Heizeinrichtung in einer Kammer in Abhängigkeit von der in der fünften Vorrichtung ermittelten zweiten Temperatur zu erstellen und an diese zu übertragen, wobei die Kammer für das Bearbeiten, Inspizieren, Transportieren, Heizen, Kühlen oder Schleusen des mindestens einen Substrats geeignet ist.

14. System nach einem der Ansprüche 7 bis 13, **dadurch gekennzeichnet, dass** die erste Vorrichtung gleichartige Lasersensoren zum Ermitteln des ersten Parametersets aufweist wie die vierte Vorrichtung.

Fig. 1

Fig. 2

EP 3 236 492 A1

$T = T_0$

$T = T_i$

Fig. 3A

Fig. 3B

Fig. 4

Fig.5

Bereitstellen des Substratträgers 100 — S10

Ermitteln des ersten Parametersets bei $T_0$ — S20

Ermitteln der Positionen des Bezugspunktes 120 und des Substratbezugspunktes 130 bei $T_0$ sowie der Vorrichtung 200 — S30

Positionieren des Substratträgers 100 bei $T_i$ an erster Position — S40

Ermitteln des zweiten Parametersets bei $T_i$ an erster Position — S50

Ermitteln der Position des Substratbezugspunktes 130 bei $T_i$ an erster Position — S60

Steuerung der Vorrichtung 200 in Abhängigkeit von der ermittelten Position des Substratbezugspunktes 130 bei $T_i$ an erster Position — S70

Fig. 6

Fig. 7

Fig. 8

100

541    542

$L_i$

130

120

$T = T_i$

y

z ⊙ → x

Fig. 9

100

541    542

$L_i'$

$L_i$

120    130

d

543

$T = T_i$

y

z ⊙ → x

β

Fig. 10

# EP 3 236 492 A1

**EUROPÄISCHER RECHERCHENBERICHT**

Nummer der Anmeldung

EP 16 16 5811

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | US 4 984 731 A (IMAMURA TETSUICHI [JP]) 15. Januar 1991 (1991-01-15) * Spalte 1, Zeile 20 - Spalte 4, Zeile 2 * * Abbildungen 1-4 * ----- | 1-14 | INV. H01L21/68 H01L21/67 |
| Y | US 5 350 899 A (ISHIKAWA HIROICHI [US] ET AL) 27. September 1994 (1994-09-27) * Spalte 5, Zeile 54 - Spalte 7, Zeile 52 * * Abbildungen 1,2,7 * ----- | 1-14 | |
| A | US 2002/135776 A1 (NISHI KENJI [JP]) 26. September 2002 (2002-09-26) * Absatz [0103] - Absatz [0109] * * Abbildung 2(a) * ----- | 1,3,4, 7-9 | |
| A | US 2009/219969 A1 (YAMAMOTO TAKESHI [JP]) 3. September 2009 (2009-09-03) * das ganze Dokument * ----- | 1,7 | |
| A | US 5 325 180 A (CHAPPELOW RONALD E [US] ET AL) 28. Juni 1994 (1994-06-28) * das ganze Dokument * ----- | 1,7 | **RECHERCHIERTE SACHGEBIETE (IPC)** H01L |

Der vorliegende Recherchenbericht wurde für alle Patentansprüche erstellt

| Recherchenort | Abschlußdatum der Recherche | Prüfer |
|---|---|---|
| Den Haag | 10. Oktober 2016 | Meixner, Matthias |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 16 16 5811

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-10-2016

| Im Recherchenbericht angeführtes Patentdokument | Datum der Veröffentlichung | Mitglied(er) der Patentfamilie | Datum der Veröffentlichung |
|---|---|---|---|
| US 4984731 A | 15-01-1991 | KEINE | |
| US 5350899 A | 27-09-1994 | AU 3945993 A<br>CA 2132851 A1<br>EP 0636276 A1<br>JP 2848704 B2<br>JP H07505744 A<br>TW 289136 B<br>US 5350899 A<br>WO 9321656 A1 | 18-11-1993<br>28-10-1993<br>01-02-1995<br>20-01-1999<br>22-06-1995<br>21-10-1996<br>27-09-1994<br>28-10-1993 |
| US 2002135776 A1 | 26-09-2002 | KEINE | |
| US 2009219969 A1 | 03-09-2009 | CN 101527274 A<br>JP 4515509 B2<br>JP 2009212199 A<br>US 2009219969 A1 | 09-09-2009<br>04-08-2010<br>17-09-2009<br>03-09-2009 |
| US 5325180 A | 28-06-1994 | KEINE | |

Für nähere Einzelheiten zu diesem Anhang : siehe Amtsblatt des Europäischen Patentamts, Nr.12/82

EPO FORM P0461